# EUROPEAN PATENT SPECIFICATION

(11) **EP 4 394 850 B1**
(45) Date of publication and mention of the grant of the patent: **25.03.2026**
(21) Application number: 21955164.5
(22) Date of filing: 29.10.2021
(51) Int. Cl.: H01L 21/67, H01J 37/32, H01L 21/68

(54) **SUBSTRATE PROCESSING DEVICE AND DIELECTRIC PLATE ALIGNMENT METHOD**
SUBSTRATVERARBEITUNGSVORRICHTUNG UND AUSRICHTUNGSVERFAHREN FÜR DIELEKTRISCHE PLATTEN
DISPOSITIF DE TRAITEMENT DE SUBSTRAT ET PROCÉDÉ D'ALIGNEMENT DE PLAQUE DIÉLECTRIQUE

(30) Priority: 25.08.2021 KR 20210112160
(43) Date of publication of application: 03.07.2024
(73) Proprietor: PSK Inc., Hwaseong-si, Gyeonggi-do 18849 (KR)
(72) Inventor: YOO, Kwang-Sung, Hwaseong-si Gyeonggi-do 18849 (KR); PARK, Ju-Young, Hwaseong-si Gyeonggi-do 18849 (KR)
(74) Representative: HGF
(86) International application number: PCT/KR2021/015421
(87) International publication number: WO 2023/027245

(56) References cited:
- KR-B1- 100 911 747
- KR-B1- 100 911 747
- KR-B1- 101 346 081
- KR-B1- 102 275 757
- KR-B1- 102 275 757
- US-A1- 2008 179 297
- US-A1- 2008 185 105

## Description

### Technical Field

The present invention relates to a substrate processing apparatus and a method of aligning a dielectric plate, and more particularly to a substrate processing apparatus for processing a substrate by using plasma and a method of aligning a dielectric plate provided therein.

### Background Art

Plasma refers to an ionized gas state formed of ions, radicals, electrons, and the like, and is generated by a very high temperature, strong electric fields, or RF electromagnetic fields. A semiconductor device manufacturing process includes an ashing or etching process of removing a membrane on a substrate by using plasma. The ashing or etching process is performed when ions and radical particles contained in the plasma collide or react with the membrane on the substrate. The process of processing the substrate by using the plasma is performed by various methods. Among them, a bevel etch device, which processes the edge region of the substrate, processes the edge region of the substrate by delivering plasma to the edge region of the substrate.

In the bevel etch device, process gas excited to a plasma state is supplied to the edge of the substrate to etch the substrate. To prevent etching of the rest of the substrate except the edge region, a dielectric plate provided as an insulator is placed on the top of the substrate. It is important to adjust the relative position of the dielectric plate and the substrate in order to process only the edge region of the substrate.

However, providing a separate structure for moving the dielectric plate for this purpose causes space limitations in configuring the interior of a typical bevel etch device and increases the volume of the bevel etch device. KR 102 275 757 B1 discloses an example of a prior art bevel etch system. KR 100 911 747 B1 discloses a substrate processing apparatus with a mechanism to horizontally align an upper electrode with a lower electrode.

### Technical Problem

The present invention has been made in an effort to provide a substrate processing apparatus and a method of aligning a dielectric plate that are capable of efficiently adjusting a relative position of an insulator and a substrate.

The present invention has also been made in an effort to provide a substrate processing apparatus and a method of aligning a dielectric plate that are capable of further improving plasma processing efficiency for an edge region of a substrate. Therefore, according to the invention a substrate processing apparatus as defined in claim 1 and a method of aligning the dielectric plate of a substrate processing apparatus as defined in claim 11 are provided. Further preferred embodiments of the invention are defined in the dependent claims.

The problem to be solved by the present invention is not limited to the above-mentioned problems, and the problems not mentioned will be clearly understood by those skilled in the art from the present specification and the accompanying drawings.

### Technical Solution

An exemplary embodiment of the present invention provides a substrate processing apparatus including: a housing with an open top and having a processing space therein; a gas supply unit for supplying gas to the processing space; a support unit including a chuck supporting a substrate in the processing space and a lower electrode provided to surround the chuck when viewed from above; a dielectric plate unit including a dielectric plate disposed opposite to the substrate supported by the support unit in the processing space; an upper electrode unit coupled to the dielectric plate unit, and including an upper electrode disposed opposite the lower electrode; and an alignment unit for aligning a disposition in a horizontal direction of the dielectric plate unit, in which a top portion of the housing is provided with a lead extending in the horizontal direction from the housing and coupled to the upper electrode unit, and the alignment unit is coupled to the lead

In the exemplary embodiment, alignment unit may include: a body coupled to the lead; and a plurality of alignment bolts insertably provided in threads formed in the body and provided for pushing the upper electrode unit in the horizontal direction.

In the exemplary embodiment, the body may be provided in a form detachably from the lead.

In the exemplary embodiment, the lead may be provided in a ring shape, and the alignment bolts may be provided to be symmetrical about a center of the lead.

In the exemplary embodiment, the lead may be coupled with the upper electrode unit through a bolt.

In the exemplary embodiment, the substrate processing apparatus may further include: a view port penetrating the dielectric plate unit; and an alignment mark provided on the support unit to correspond to the view port at a preset position.

In the exemplary embodiment, when viewed from above, the view port may be provided at a position that does not overlap the lead.

In the exemplary embodiment, the dielectric plate unit and the upper electrode unit may be coupled to a temperature control plate.

In the exemplary embodiment, the dielectric plate unit may further include a first base disposed between the dielectric plate and the temperature control plate, and the upper electrode unit may further include a second base that surrounds the first base when viewed from above, and is disposed between the upper electrode and the temperature control plate.

In the exemplary embodiment, the gas supply unit ma include: a gas channel formed in a space in which the first base and the second base are spaced apart from each other; and a first gas supply unit for supplying process gas excited to plasma into the gas channel, and a discharge end of the gas channel may head an edge region of the substrate supported by the support unit.

In the exemplary embodiment, the gas supply unit may include: a gas flow path provided within the dielectric plate; and a second gas supply unit for supplying inert gas into the gas flow path, and a discharge end of the gas flow path may be formed to head a center region of the substrate supported by the support unit.

Another exemplary embodiment of the present invention provides a method of aligning the dielectric plate, the method including: aligning the dielectric plate to a preset position relative to the support unit before or after processing a substrate within the processing space, in which when the dielectric plate is not aligned in the preset position, the dielectric plate is aligned in the preset position by tightening any of the alignment bolts to move the upper electrode unit from side to side.

In the exemplary embodiment, the alignment unit may be provided detachably from the lead.

In the exemplary embodiment, the lead may be coupled with the upper electrode unit through a bolt, the lead and the upper electrode unit may be fully coupled with each other while the substrate is being processed within the processing space, and the lead and the upper electrode unit may be loosely coupled with each other while the dielectric plate is being aligned.

In the exemplary embodiment, the preset position for the alignment of the dielectric plate may be a position at which the support unit is placed while the substrate is being processed within the processing space.

In the exemplary embodiment, any one of the alignment bolts may be tightened so that a view port penetrating the dielectric plate unit and an alignment mark provided on the support unit to correspond to the view port are in line with each other.

### [Advantageous Effects]

According to the exemplary embodiment of the present invention, it is possible to efficiently process a substrate.

Further, according to the exemplary embodiment of the present invention, it is possible to uniformly perform plasma treatment on a substrate.

Furthermore, according to the exemplary embodiment of the present invention, it is possible to further improve plasma treatment efficiency for an edge region of a substrate.

The effect of the present invention is not limited to the foregoing effects, and the not-mentioned effects will be clearly understood by those skilled in the art from the present specification and the accompanying drawings.

### Description of Drawings

FIG. 1 is a diagram schematically illustrating a substrate processing apparatus according to an exemplary embodiment of the present invention.
FIG. 2 is a diagram illustrating the substrate processing apparatus provided to a process chamber of FIG. 1 according to an exemplary embodiment.
FIG. 3 is a diagram illustrating a substrate processing apparatus according to an exemplary embodiment of the present invention.
FIGS. 4 to 6 are each drawings illustrating aligning dielectric plates according to the exemplary embodiment of the present invention.
FIG. 7 is a diagram illustrating a substrate processing apparatus according to another exemplary embodiment of the present invention.

### Best Mode

Hereinafter, an exemplary embodiment of the present invention will be described more fully hereinafter with reference to the accompanying drawings, in which exemplary embodiments of the invention are illustrated. However, the present invention can be variously implemented and is not limited to the following exemplary embodiments. In the following description of the present invention, a detailed description of known functions and configurations incorporated herein is omitted to avoid making the subject matter of the present invention unclear. In addition, the same reference numerals are used throughout the drawings for parts having similar functions and actions.

Unless explicitly described to the contrary, the word "include" will be understood to imply the inclusion of stated elements but not the exclusion of any other elements. It will be appreciated that terms "including" and "having" are intended to designate the existence of characteristics, numbers, operations, operations, constituent elements, and components described in the specification or a combination thereof, and do not exclude a possibility of the existence or addition of one or more other characteristics, numbers, operations, operations, constituent elements, and components, or a combination thereof in advance.

Singular expressions used herein include plurals expressions unless they have definitely opposite meanings in the context. Accordingly, shapes, sizes, and the like of the elements in the drawing may be exaggerated for clearer description.

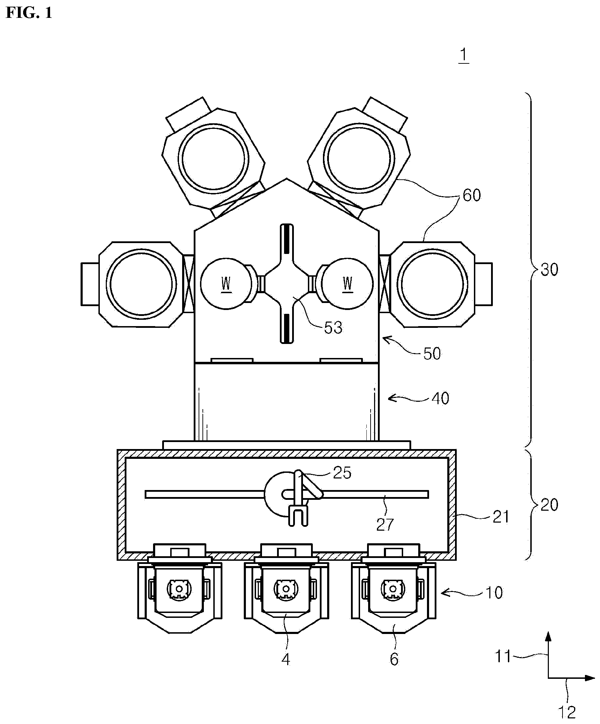

FIG. 1 is a diagram schematically illustrating a substrate processing facility according to an exemplary embodiment of the present invention. Referring to FIG. 1, substrate processing equipment 1 has an equipment front end module (EFEM) 20 and a processing module 30. The EFEM 20 and the treating module 30 are disposed in one direction.

The EFEM 20 includes a load port 10 and a transfer frame 21. The load port 10 is disposed in front of the EFEM 20 in a first direction 11. The load port 10 includes a plurality of support parts 6. The support parts 6 are disposed in series in a second direction 12, and a carrier 4 (for example, a cassette, and an FOUP) in which a substrate W that is to be provided for a process and a processing completed substrate W is accommodated is seated on each support part 6. In the carrier 4, the substrate W that is to be provided for a process and the process completed substrate W are accommodated. The transfer frame 21 is disposed between the load port 10 and the treating module 30. The transfer frame 21 includes a first transfer robot 25 which is disposed inside the transfer frame 21 and transfers the substrate W between the load port 10 and the processing module 30. The first transfer robot 25 moves along a transfer rail 27 provided in the second direction 12 to transfer the substrate W between the carrier 4 and the processing module 30.

The processing module 30 includes a load lock chamber 40, a transfer chamber 50, and a process chamber 60. The treating module 30 may treat the substrate W by receiving the substrate W from the EFEM 20.

The load lock chamber 40 is disposed to be adjacent to the transfer frame 21. For example, the load lock chamber 40 may be disposed between the transfer chamber 50 and the EFEM 20. The load lock chamber 40 provides a place in which the substrate W to be provided for the process stands by before being transferred to the process chamber 60, or the processing completed substrate W stands by before being transferred to the EFEM 20.

The transfer chamber 50 may transfer the substrate W. The transfer chamber 50 is disposed to be adjacent to the load lock chamber 40. The transfer chamber 50 has a polygonal body when viewed from above. Referring to FIG. 1, the transfer chamber 50 has a pentagonal body when viewed from above. At the external side of the body, the load lock chamber 40 and the plurality of process chambers 60 are disposed along a circumference of the body. A passage (not illustrated) through which the substrate W enters and exists is formed on each sidewall of the body, and the passage connects the transfer chamber 50 and the load lock chamber 40 or the process chambers 60. Each passage is provided with a door (not illustrated) which opens/closes the passage to seal the interior. The second transfer robot 53 which transfers the substrate W between the load lock chamber 40 and the process chambers 60 is disposed in an internal space of the transfer chamber 50. The second transfer robot 53 transfers the untreated substrate W waiting in the load lock chamber 40 to the process chamber 60 or transfers the process completed substrate W to the load lock chamber 40. Then, the second transfer robot 53 transfers the substrate W between the process chambers 60 to sequentially provide the substrate W to the plurality of process chambers 60. As illustrated in FIG. 1, when the transfer chamber 50 has the pentagonal body, the load lock chamber 40 is disposed on the sidewall adjacent to the EFEM 20, and the process chambers 60 are consecutively disposed on the remaining sidewalls. The transfer chamber 50 may be provided in various forms depending on a demanded process module, as well as the foregoing shape.

The process chamber 60 may be disposed to be adjacent to the transfer chamber 50. The process chambers 60 are disposed along the circumference of the transfer chamber 50. The plurality of process chambers 60 may be provided. In each process chamber 60, the process processing may be performed on the substrate W. The process chamber 60 may receive the substrate W from the second transfer robot 53 and perform the process processing, and provides the second transfer robot 53 with the substrate W for which the process processing is completed. The process processing performed in the respective process chambers 60 may be different from each other.

Hereinafter, a substrate processing apparatus performing a plasma process in the process chamber 60 will be described. In addition, the substrate processing apparatus described herein is described by way of example in which the substrate processing apparatus is configured to perform a plasma treatment process on an edge region of a substrate. However, without limitation, the substrate processing apparatus described herein may be equally or similarly applicable to a variety of chambers in which processing of a substrate is performed. Furthermore, the substrate processing apparatus may be equally or similarly applicable to the various chambers in which the plasma treatment process for the substrate is performed.

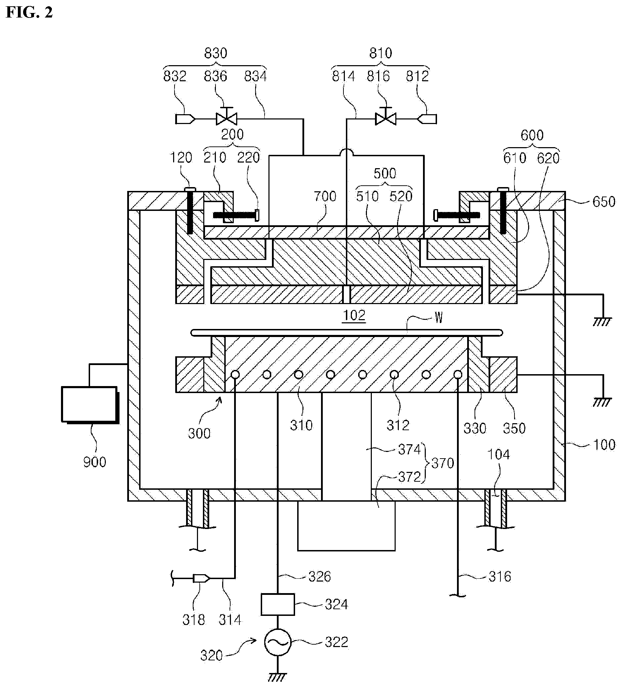

FIG. 2 is a diagram illustrating the substrate processing apparatus provided to a process chamber of FIG. 1 according to an exemplary embodiment. Referring to FIG. 2, the substrate processing apparatus provided to the process chamber 60 performs a predetermined process on the substrate W by using plasma. For example, the substrate processing apparatus may etch or ash a membrane on the substrate W. The membrane may be various types of membrane, such as a poly silicon film, a silicon oxide film, a silicon nitride film. Further, the membrane may be a natural oxide film or a chemically produced oxide film. Further, the membrane may be a byproduct generated in a process of processing the substrate W. Further, the membrane may be impurities attached and/or left on the substrate W.

The substrate processing apparatus may perform a plasma process on the substrate W. For example, the substrate processing apparatus may process the substrate W by supplying process gas and generating plasma from the supplied process gas. The substrate processing apparatus may process an edge region of the substrate W by supplying process gas and generating plasma from the supplied process gas. Hereinafter, the present invention will be described based on an example in which the substrate processing apparatus is a bevel etch device performing etching processing on the edge region of the substrate W.

The substrate processing apparatus may include a housing 100, a support unit 300, a dielectric plate unit 500, an upper electrode unit 600, a temperature control plate 700, a gas supply unit 800, and an alignment unit 200.

The housing 100 may have a processing space 102 therein. An opening (not shown) may be formed in one surface of the housing 100. In one example, an opening may be formed in any one of the sides of the housing 100. The substrate W may be loaded into or unloaded from the processing space 102 of the housing 100 through openings formed in the housing 100. The opening may be opened and closed by an opening/closing member, such as a door (not illustrated).

In one example, the housing 100 is provided with an open top. The housing 100 may form a space sealed by a lead 650, the upper electrode unit 600, and the dielectric plate unit 500 which will be described later. When the opening in the housing 100 is opened and closed by the opening/closing member, the processing space 102 of the housing 100 may be isolated from the outside. Additionally, the atmosphere in the processing space 102 of the housing 100 may be adjusted to a low pressure near vacuum after being isolated from the outside. Further, the housing 100 may be made of a material including metal. Further, the housing 100 may have a surface thereof coated with an insulating material.

Additionally, an exhaust hole 104 may be formed in the bottom surface of the housing 100. Plasma P generated in the processing space 212 or gas G1 and G2 supplied to the processing space 102 may be exhausted to the outside through the exhaust hole 104. Further, by-products generated in the process of processing the substrate W by using the plasma P may be discharged to the outside through the exhaust hole 104. Additionally, the exhaust hole 104 may be connected to an exhaust line (not shown). The exhaust line may be connected to a decompression member that provides decompression. The decompression member may provide decompression to the processing space 102 via an exhaust line.

The support unit 200 may support the substrate W in the processing space 102. The support unit 300 may include a chuck 310, a power member 320, an insulating ring 330, a lower electrode 350, and a drive member 370.

The chuck 310 may have a support surface supporting the substrate W. The chuck 310 may have a circular shape when viewed from above. The chuck 310 may have a diameter smaller than a diameter of the substrate W when viewed above. Accordingly, a center region of the substrate W supported by the chuck 310 is seated on the support surface of the chuck 310, and an edge region of the substrate W may not be in contact with the support surface of the chuck 310.

A heating means (not illustrated) may be provided inside the chuck 310. The heating means (not illustrated) may heat the chuck 310. The heating means may be a heater. Further, a cooling flow path 312 may be formed in the chuck 310. The cooling flow path 312 may be formed inside the chuck 310. A cooling fluid supply line 314 and a cooling fluid discharge line 316 may be connected to the cooling flow path 312. The cooling fluid supply line 314 may be connected with a cooling fluid supply source 318. The cooling fluid supply source 318 may store a cooling fluid and/or supply a cooling fluid to the cooling fluid supply line 314. Further, the cooling fluid supplied to the cooling flow path 312 may be discharged to the outside through the cooling fluid discharge line 316. The cooling fluid stored in and/or supplied by the cooling fluid supply source 318 may be cooling water or cooling gas. Further, the shape of the cooling flow path 312 formed in the chuck 310 is not limited to the shape illustrated in FIG. 2, and may be variously transformed. Further, the configuration for cooling the chuck 310 is not limited to a configuration that provides a cooling fluid, but may be provided in a variety of configurations (for example, a cooling plate) that is capable of cooling the chuck 310.

The power member 320 may provide power to the chuck 310. The power supply member 320 may include a power supply 322, a matcher 324, and a power supply line 326. The power supply 322 may be a bias power supply. The power supply 322 may be connected with the chuck 310 via the power supply line 326. Further, the matcher 324 is provided to the power supply line 326 to perform impedance matching.

The insulating ring 330 may be provided to have a ring shape when viewed from above. For example, the insulating ring 330 may be provided to surround the chuck 310 when viewed from above. For example, the insulating ring 330 may have a ring shape. Further, the insulating ring 330 may be stepped such that a height of the top surface of the inner region is different from a height of the top surface of the outer region. For example, the insulating ring 330 may be stepped so that a height of the top surface of the inner region is higher than a height of the top surface of the outer region. When the substrate W is seated on the support surface of the chuck 310, the upper surface of the inner region between the upper surface of the inner region and the upper surface of the outer region of the insulating ring 330 may be in contact with the bottom surface of the substrate W. Further, when the substrate W is seated on the support surface of the chuck 310, the top surface of the outer region between the upper surface of the inner region and the top surface of the outer region of the insulating ring 330 may be spaced apart from the bottom surface of the substrate W. The insulating ring 330 may be provided between the chuck 310 and the lower electrode 350 described later. Since the chuck 310 is provided with a bias power source, the insulating ring 330 may be provided between the chuck 310 and the lower electrode 350 which is to be described below. The insulating ring 330 may be made of a material having an insulating property.

The lower electrode 350 may be disposed below the edge region of the substrate W supported on the chuck 310. The lower electrode 350 may be provided to have a ring shape when viewed from above. The lower electrode 350 may be provided to surround the insulating ring 330 when viewed from above. The top surface of the lower electrode 350 may be provided at the same height as that of the outer top surface of the insulating ring 330. The lower surface of the lower electrode 350 may be provided at the same height as the lower surface of the insulating ring 330. Additionally, the top surface of the lower electrode 350 may be provided lower than the top surface of the center portion of the chuck 310. Additionally, the lower electrode 350 may be provided to be spaced apart from the bottom surface of the substrate W supported on the chuck 310. For example, the lower electrodes 350 may be provided to be spaced apart from the bottom surface of the edge region of the substrate W supported on the chuck 310.

The lower electrode 350 may be disposed to face the upper electrode 620 which is to be described later. The lower electrode 350 may be disposed under the upper electrode 620 which is to be described below. The lower electrode 350 may be grounded. The lower electrode 350 may increase the plasma density by inducing coupling of the bias power applied to the chuck 310. Thus, the processing efficiency for the edge region of the substrate W may be improved.

The driving member 370 may lift the chuck 310. The drive member 370 may include a driver 372 and a shaft 374. The shaft 374 may be coupled with the chuck 310. The shaft 374 may be connected with the driver 372. The driver 372 may move up and down the chuck 310 in the vertical direction via the shaft 374.

The dielectric plate unit 500 may include the dielectric plate 520 and a first base 510. Further, the dielectric plate unit 500 may be coupled to a temperature adjustment plate 700 which is to be described below.

The dielectric plate 520 may have a circular shape when viewed from above. In one example, the underside of the dielectric plate 520 may be provided in a flat shape. The dielectric plate 520 may be disposed opposite the substrate W supported by the support unit 300 in the processing space 102. For example, the dielectric plate 520 may be disposed above the support unit 300. The dielectric plate 520 may be made of a material including ceramic. A gas flow path connected with a first gas supply unit 810 of the gas supply unit 800, which will be described below, may be formed in the dielectric plate 520. Further, a discharge end of the gas flow path may be configured so that first gas G1 supplied by the first gas supply unit 810 is supplied to the center region of the substrate W supported by the support unit 300. Further, the discharge end of the gas flow path may be configured so that the first gas G1 is supplied to the upper surface of the center region of the substrate W supported by the support unit 300.

The first base 510 may be disposed between the dielectric plate 520 and the temperature adjustment plate 700 which is to be described below. The first base 510 may be coupled to the temperature adjustment plate 700 which is to be described below, and the dielectric plate 520 may be coupled to the first base 510. Accordingly, the dielectric plate 520 may be coupled to the temperature adjustment plate 700 via the first base 510.

In one example, the top surface of the first base 510 may have a smaller diameter than the bottom surface of the dielectric plate 520. The upper surface of the first base 510 may have a flat shape. Further, a lower surface of the first base 510 may have a stepped shape. For example, the lower surface of the first base 510 may be stepped so that a height of the lower surface of the edge region of the first base 510 is smaller than a height of the lower surface of the center region. Further, the lower surface of the first base 510 and the upper surface of the dielectric plate 520 may have shapes that may be combined with each other. In one example, the first base 510 may be provided of a material including metal. For example, the first base 510 may be made of a material including aluminum.

The upper electrode unit 600 may include a second base 610, and the upper electrode 620. Further, the upper electrode unit 600 may be coupled to the temperature adjustment plate 700, which is described later.

The upper electrode 620 may be opposed to the lower electrode 350 described above. The upper electrode 620 may be disposed above the lower electrode 350. The upper electrode 620 may be disposed in the upper portion of the edge region of the substrate W supported on the chuck 310. The upper electrode 620 may be grounded.

The upper electrode 620 may have a shape that surrounds the dielectric plate 520 when viewed from above. In one example, the upper electrode 620 may be provided in a ring shape. The upper electrode 620 may be spaced apart from the dielectric plate 520 to form a gap space. The gap space may form a part of the gas channel in which the second gas G2 supplied by the second gas supply unit 830, which will be described below, flows. A discharge end of the gas channel may be configured so that the second gas G2 is supplied to the edge region of the substrate W supported by the support unit 300. Further, the discharge end of the gas channel may be configured so that the second gas G2 is supplied to the upper surface of the edge region of the substrate W supported by the support unit 300.

The second base 610 may be disposed between the upper electrode 620 and the temperature adjustment plate 700 which is to be described later. The second base 610 may be coupled to the temperature adjustment plate 700 which is to be described later, and the upper electrode 620 may be coupled to the second base 610. Accordingly, the upper electrode 620 may be coupled to the temperature adjustment plate 700 via the second base 610.

The second base 610 may have a ring shape when viewed from above. The top surface and the lower surface of the second base 610 may have a flat shape. When viewed from above, the second base 610 may have a shape surrounding the first base 510. In one example, the inner surface of the second base 610 may have a shape that is engaged with the outer surface of the first base 510. The second base 610 may be provided to be spaced apart from the first base 510. The second base 610 may be spaced apart from the first base 510 to form a gap space. The gap space may form a part of the gas channel in which the second gas G2 supplied by the second gas supply unit 830, which will be described below, flows. Further, the second bas 610 may be made of a material including metal. For example, the second base 610 may be made of a material including aluminum.

The temperature adjustment plate 700 may be coupled with the dielectric plate unit 500 and the upper electrode unit 600. The temperature adjustment plate 700 may be coupled to the housing 100 via the leads 650 described later. The temperature adjustment plate 700 may generate heat. For example, the temperature adjustment plate 700 may generate hot or cold heat. The temperature adjustment plate 700 may receive a signal from a controller 900, described later, to generate heat. The temperature adjustment plate 700 may generate hot or cold heat, so that the temperature of the dielectric plate unit 500 and the upper electrode unit 600 may be controlled to remain relatively constant. For example, the temperature adjustment plate 700 generates cold heat, so that the temperature of the dielectric plate unit 500 and the upper electrode unit 600 may be suppressed as much as possible from becoming excessively high in the process of treating the substrate W.

The gas supply unit 800 may supply gas to the processing space 102. The gas supply unit 800 may supply first gas G1 and second gas G2 to the processing space 102. The gas supply unit 800 may include a first gas supply unit 810 and a second gas supply unit 830.

The first gas supply unit 810 may supply the first gas G1 to the processing space 102. The first gas G1 may be inert gas, such as nitrogen. The first gas supply unit 810 may supply the first gas G1 to the center region of the substrate W supported by the chuck 310. The first gas supply unit 810 may include a first gas supply source 812, a first gas supply line 814, and a first valve 816. The first gas supply source 812 may store the first gas G1 and/or supply the first gas G1 to the first gas supply line 814. The first gas supply line 814 may be connected with the flow path formed in the dielectric plate 520. The first valve 816 may be installed in the first gas supply line 814. The first valve 816 may be an on/off valve, or provided as a flow rate adjustment valve. The first gas G1 supplied by the first gas supply source 812 may be supplied to the center region of the upper surface of the substrate W through the flow path formed in the dielectric plate 520.

The second gas supply unit 830 may supply the second gas G2 to the processing space 102. The second gas G2 may be process gas excited to a plasma state. The second gas supply unit 830 may supply the second gas G2 to the edge region of the substrate W through a gas channel formed by the dielectric plate 520, the first base 510, the upper electrode 620, and the second base 610 spaced apart from each other above the edge region of the substrate W supported on the chuck 310. The second gas supply unit 830 may include a second gas supply source 832, a second gas supply line 834, and a second valve 836. The second gas supply source 832 may store the second gas G2 and/or supply the second gas G2 to the second gas supply line 834. The second gas supply line 814 may supply the second gas G2 to the gap space functioning as the gas channel. The second valve 836 may be installed in the second gas supply line 834. The second valve 836 may be an on/off valve, or provided as a flow rate adjustment valve. The second gas G2 supplied by the second gas supply source 832 may be supplied to the edge region of the top surface of the substrate W through the second flow path 602.

The controller 900 may control the substrate processing apparatus. The controller 900 may control the substrate processing apparatus so as to perform a plasma processing process performed below. For example, the controller 900 may control the gas supply unit 800, the temperature adjustment plate 700, and the support unit 300. For example, the controller 900 may control the support unit 300 and the gas supply unit 800 so that when the first gas supply unit 810 and/or the second gas supply unit 830 supplies gas, the power supply 322 applies power to the chuck 310 to generate plasma P in the edge region of the substrate W supported by the chuck 310.

The alignment unit 200 aligns the horizontal disposition of the dielectric plate unit 500. In one example, the alignment unit 200 is coupled to the lead 650. The lead 650 is coupled to the upper electrode unit 600. The lead 650 is provided on a top of the housing 100 and extends horizontally from the housing 100 toward an interior space of the housing 100. In one example, the housing 100 is provided in a cylindrical shape with an open top, and the lead 650 is provided in a ring shape. In one example, the lead 650 may be provided from the same material as the housing 100. In one example, the lead 650 and the housing 100 may be grounded.

In one example, the lower surface of the lead 650 is provided at a higher position than the upper surface of the temperature control plate 700.

In one example, the alignment unit 200 has a body 210 and an alignment bolt 220. The body 210 is coupled to the lead 650. In one example, the body 210 is provided in a form that is removably attached to the lead 650. Thus, the body 210 may be attached when aligning the horizontal disposition of the dielectric plate unit 500, and the body 210 may remain detached from the lead 650 during processing of the substrate W within the housing 100. In one example, the body 210 is coupled to the inner diameter of the lead 650. A lower surface of the body 210 is spaced apart from an upper surface of the thermostatic plate 700.

In one example, a cross-section of the body 210 is provided to have a horizontal portion horizontal to the lead 650 and a bent portion bent from the horizontal portion. For example, the cross-section of the body 210 is provided in a shape of " 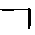 ". The bent portion is formed with a thread in a direction parallel to the horizontal portion. The alignment bolt 220 is provided to be insertable into the thread formed in the bent potion. One end of the alignment bolt 220 is provided to be selectively in contact with the upper electrode unit 600. The alignment unit 200 moves the upper electrode unit 600 coupled to the lead 650 finely in the horizontal direction to align the horizontal disposition of the dielectric plate unit 500 coupled to the upper electrode unit 600. In one example, one end of the alignment bolt 220 is provided to be selectively in contact with the second base. One end of the alignment bolt 220 is provided to push the second base in the horizontal direction upon tightening the alignment bolt 220. In one example, a plurality of alignment bolts 220 is provided. In one example, the alignment bolts 220 are provided to be symmetrical about the center of the lead 650 when viewed from the top. For example, two alignment bolts 220 are provided 180 degrees apart when viewed from the top. Accordingly, one alignment bolt 220 pushes the second base to the right as the alignment bolt 220 is tightened, and the other alignment bolt 220 pushes the second base to the left as the alignment bolt 220 is tightened. Alternatively, the alignment bolts 220 may be spaced at the same angle when viewed from above, but may be provided in a greater number than two.

In one example, the lead 650 and the upper electrode unit 600 are provided in a manner that is capable of selectively providing coupling force between the lead 650 and the upper electrode unit 600. For example, the lead 650 and the upper electrode unit 600 are coupled by a bolt 120. Alternatively, the lead 650 and the upper electrode unit 600 may be coupled by other means that is capable of variably providing coupling force between them. Accordingly, when the horizontal disposition of the dielectric plate unit 500 is aligned, the coupling force between the lead 650 and the upper electrode unit 600 may be provided relatively weak to allow one end of the alignment bolt 220 to push and move the upper electrode unit 600, and when the substrate W is processed within the processing space 102, the coupling force between the lead 650 and the upper electrode unit 600 may be provided stronger to seal the processing space 102 so that the processing space 102 may be vacuumed.

In the example described above, the lead 650 was described as being provided as a separate component from the housing 100, but the lead 650 may be provided integral with the housing 100.

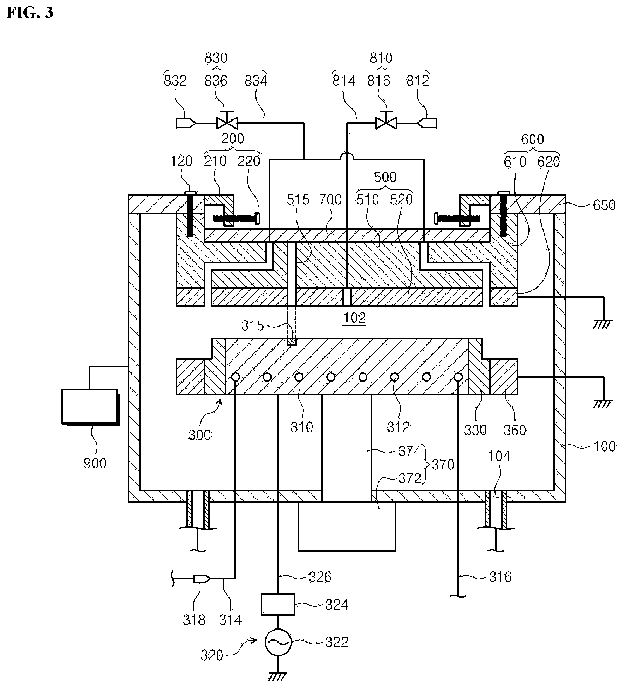

FIG. 3 is a diagram illustrating the substrate W processing apparatus according to an exemplary embodiment of the present invention. In one example, the dielectric plate unit 500 may be provided with a view port 515 and the support unit 300 may be provided with an alignment mark 315.

The view port 515 is provided to penetrate the dielectric plate unit 500. When viewed from above, the view port 515 is provided in a position that does not overlap the lead 650. Accordingly, a view port 515 is provided to allow an operator to visually look into the processing space 102 through the view port 515. The alignment mark 315 is provided to correspond with the view port 515 at a preset position. In one example, the preset position is the position of the support unit 300 while the substrate W is being processed within the processing space 102. In one example, the alignment mark 315 may be provided as a groove on the support unit 300. Alternatively, the alignment mark 315 may be provided in various forms that are visually visible to an operator. The operator determines that the dielectric plate unit 500 is aligned in place when the alignment mark 315 is visually visible through the view port 515. When the alignment mark 315 is not visible to the naked eye, the dielectric plate unit 500 is moved horizontally by adjusting the alignment bolt 220 so that the view port 515 and the alignment mark 315 are located in line.

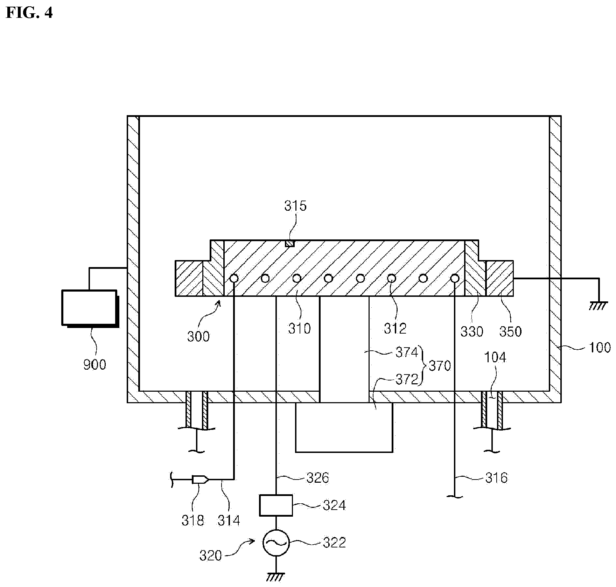

Hereinafter, a method of aligning the dielectric plate 520 of the present invention will be described with reference to FIGS. 4 to 6.

In one example, the dielectric plate 520 may be aligned to a preset position relative to the support unit 300 before or after the substrate W is processed within the processing space 102. Before or after the substrate W is processed within the processing space 102, the dielectric plate 520 is aligned in the state where the substrate W is provided within the processing space 102. In one example, the processing of the substrate W is bevel etching to etch the edge region of the substrate W.

First, the dielectric plate unit 500 and the upper electrode unit 600 may be removed from the housing 100 for maintenance of the dielectric plate unit 500 or the upper electrode unit 600 before or after the substrate W is processed within the processing space 102, as shown in FIG. 4. In this case, the lead 650 may be removed along with the dielectric plate unit 500 and the upper electrode unit 600. Alternatively, or in addition, the lead 650 may not be removed.

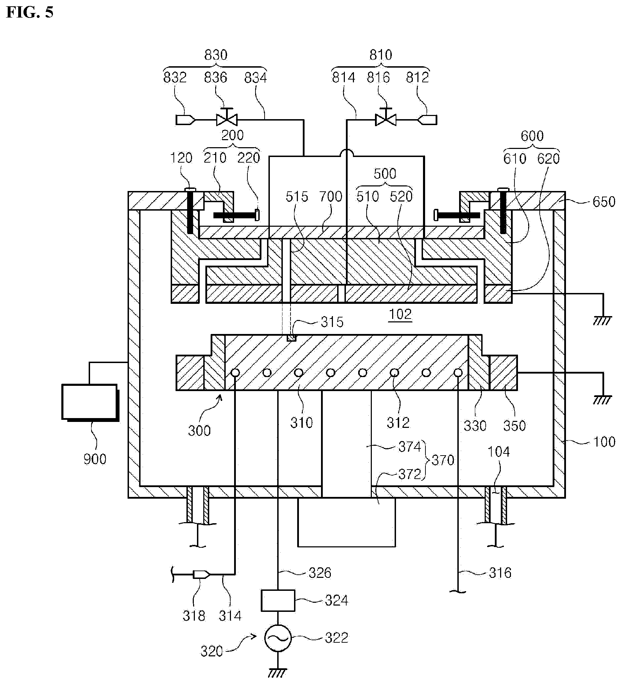

The lead 650, the dielectric plate unit 500, and the upper electrode unit 600 are then coupled to the housing 100 as shown in FIG. 5. The alignment unit 200 is then coupled to the lead 650. The positioning of the dielectric plate unit 500 is an important factor for etching the edge region of the substrate W. In particular, when the dielectric plate unit 500 is not positioned correctly, the edge region of the substrate W may be etched non-uniformly with respect to the center of the substrate W. Accordingly, it is important that the dielectric plate 520 is aligned in place with respect to the center of the substrate W. However, since the substrate W is not located within the processing space 102 while the substrate W is not being processed, the horizontal position of the dielectric plate 520 is aligned with respect to the support unit 300 on which the substrate W rests. In one example, the horizontal position of the dielectric plate 520 is aligned with respect to the position where the support unit 300 is located while the substrate W is being processed within the processing space 102.

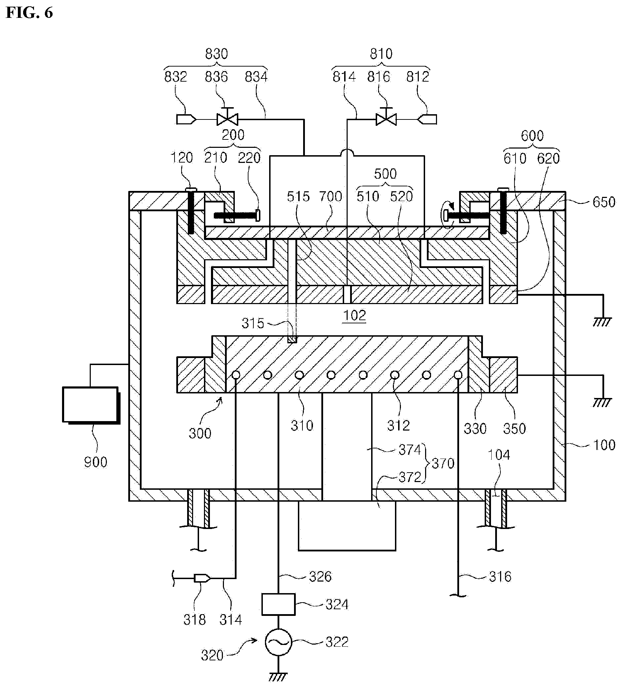

For example, as shown in FIG. 5, when the dielectric plate 520 is not aligned in the preset position, the alignment mark 315 are not visible when an operator looks into the processing space 102 through the view port 515 with the naked eye from above. At this point, the operator may tighten any one of the alignment bolts 220 to move the upper electrode unit 600 from side to side when viewed from above to align the dielectric plate 520 to the preset position. In this case, the lead 650 and the upper electrode unit 600 are loosely coupled. The dielectric plate 520 is determined to be properly aligned in the preset position when the alignment mark 315 is visible through the view port 515, as shown in FIG. 6. When the dielectric plate 520 is aligned in the preset position, the lead 650 and the upper electrode unit 600 are completely coupled. In one example, the bolts provided between the lead 650 and the upper electrode unit 600 are tightened securely. In one example, the operator may continue to check whether the dielectric plate 520 is aligned in the preset position while tightening the bolt provided between the lead 650 and the upper electrode unit 600.

In one example, when the alignment of the dielectric plate 520 is complete, the alignment unit 200 is disconnected from the lead 650.

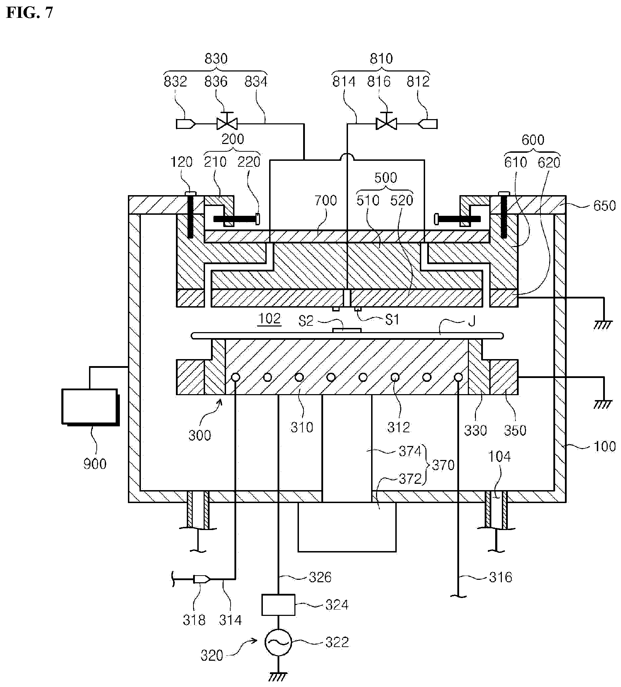

In the example described above, it has been described that the view port 515 is provided on the dielectric plate unit 500, and the operator aligns the dielectric plate 520 horizontally by visually checking the position of the alignment mark 315 provided inside the processing space 102 through the view port 515. However, as illustrated in FIG. 7, the dielectric plate 520 may be aligned in a horizontal direction by inserting a jig J having the same shape as the substrate W to which a sensor S2 is attached into the processing space 102, and transmitting a position relationship between a sensor S1 provided within the processing space 102 and the jig J to a controller provided outside the processing space 102.

In the examples described above, it has been described that the temperature adjustment plate 700 was provided separately. However, in contrast to this, the temperature control plate 700 may not be provided separately, but the second base 610 and the temperature control plate 700 may be provided integrally.

According to the present invention, it is advantageous to align the horizontal direction of the dielectric plate 520 when positioning the dielectric plate on an upper portion of the substrate to process the edge region of the substrate.

According to the present invention, it is advantageous that the alignment unit 200 for aligning the horizontal position of the dielectric plate 520 is removable.

In the examples described above, the present invention has been described based on the case where the substrate processing apparatus performs an etch process on an edge region of the substrate W as an example, but is not limited to this example. The exemplary embodiments described above may be equally or similarly applicable to a variety of facilities and processes requiring processing of the edge region of the substrate W.

The method of generating the plasma P by the substrate processing apparatus described in the foregoing example may be an Inductive Coupled Plasma (ICP) method. Further, the method of generating the plasma P by the substrate processing apparatus may be a Capacitor Couple Plasma (CCP) method. Further, the substrate processing apparatus may generate the plasma P by using both the ICP method and the CCP method or by using a selected method between the ICP method and the CCP method. In addition, the substrate processing apparatus may also process the edge region of the substrate W by generating the plasma P by any method known in the art other than the methods described above.

The foregoing detailed description illustrates the present invention. Further, the above content illustrates and describes the exemplary embodiment of the present invention, and the present invention can be used in various other combinations, modifications, and environments. That is, the foregoing content may be modified or corrected within the scope of the concept of the invention as defined in the claims. The foregoing exemplary embodiment describes the best state for implementing the technical spirit of the present invention, and various changes required in the specific application field and use of the present invention are possible. Accordingly, the detailed description of the invention above is not intended to limit the invention to the disclosed exemplary embodiment.

## Claims

1. A substrate processing apparatus, the substrate processing apparatus comprising:
a housing (100) with an open top and having a processing space (102) therein;
a gas supply unit(800) for supplying gas to the processing space (102);
a support unit (300) including a chuck (310) supporting a substrate (W) in the processing space (102) and a lower electrode (350) provided to surround the chuck (310) when viewed from above;
a dielectric plate unit (500) including a dielectric plate (520) disposed opposite to the substrate (W) supported by the support unit (300) in the processing space (102);
an upper electrode unit (600) coupled to the dielectric plate unit (500), and including an upper electrode (620) disposed opposite the lower electrode (350); and **characterised in that** the apparatus further comprising:
an alignment unit (200) for aligning a disposition in a horizontal direction of the dielectric plate unit (500),
wherein a top portion of the housing (100) is provided with a lead (650) extending in the horizontal direction from the housing (100) and coupled to the upper electrode unit (600), and the alignment unit (200) is coupled to the lead (650).

2. The substrate processing apparatus of claim 1, wherein the alignment unit (200) includes:
a body (210) coupled to the lead (650); and
a plurality of alignment bolts (220) insertably provided in threads formed in the body (210) and provided for pushing the upper electrode unit (600) in the horizontal direction.

3. The substrate processing apparatus of claim 2, wherein the body (210) is provided in a form detachably from the lead (650).

4. The substrate processing apparatus of claim 2, wherein the lead (650) is provided in a ring shape, and
the alignment bolts (220) are provided to be symmetrical about a center of the lead (650).

5. The substrate processing apparatus of claim 1, wherein the lead is coupled with the upper electrode unit (600) through a bolt (220).

6. The substrate processing apparatus of any one of claims 1 to 5, further comprising:
a view port (525) penetrating the dielectric plate unit (500); and
an alignment mark (315) provided on the support unit (300) to correspond to the view port (525) at a preset position.

7. The substrate processing apparatus of claim 6, wherein when viewed from above, the view port (525) is provided at a position that does not overlap the lead (650).

8. The substrate processing apparatus of claim 1, wherein the dielectric plate unit (500) and the upper electrode unit (600) are coupled to a temperature control plate (700).

9. The substrate processing apparatus of claim 8, wherein the dielectric plate unit (500) further includes a first base (510) disposed between the dielectric plate (520) and the temperature control plate (700), and
the upper electrode unit (600) further includes a second base (610) that surrounds the first base (510) when viewed from above, and is disposed between the upper electrode (620) and the temperature control plate (700).

10. The substrate processing apparatus of claim 9, wherein the gas supply unit includes:
a gas channel formed in a space in which the first base (510) and the second base (610) are spaced apart from each other;
a first gas supply unit (810) for supplying process gas excited to plasma into the gas channel;
a gas flow path provided within the dielectric plate (520); and
a second gas supply unit (830) for supplying inert gas into the gas flow path,
a discharge end of the gas channel heads an edge region of the substrate (W) supported by the support unit (300), and
a discharge end of the gas flow path is formed to head a center region of the substrate (W) supported by the support unit (300).

11. A method of aligning the dielectric plate by using the substrate processing apparatus of claim 2, the method comprising:
aligning the dielectric plate (520) to a preset position relative to the support unit (300) before or after processing the substrate (W) within the processing space (102),
wherein, when the dielectric plate (520) is not aligned in the preset position, the dielectric plate (520) is aligned in the preset position by tightening any of the alignment bolts (220) to move the upper electrode unit (600) from side to side.

12. The method of claim 11, wherein the alignment unit (200) is provided detachably from the lead (650).

13. The method of claim 11, wherein the lead (650) is coupled with the upper electrode unit (600) through a bolt (220),
the lead (650) and the upper electrode unit (600) are fully coupled with each other while the substrate (W) is being processed within the processing space (102), and
the lead (650) and the upper electrode unit (600) are loosely coupled with each other while the dielectric plate (520) is being aligned.

14. The method of claim 11, wherein the preset position for the alignment of the dielectric plate (520) is a position at which the support unit (300) is placed while the substrate (W) is being processed within the processing space (102).

15. The method of any one of claims 11 to 14, wherein any one of the alignment bolts (220) is tightened so that a view port (515) penetrating the dielectric plate unit (500) and an alignment mark (315) provided on the support unit (300) to correspond to the view port (515) are in line with each other.

## Patentansprüche

1. Substratverarbeitungseinrichtung, die Substratverarbeitungseinrichtung umfassend:
ein Gehäuse (100) mit einer offenen Oberseite und mit einem Verarbeitungsraum (102) darin;
eine Gaszufuhreinheit(800) zum Zuführen von Gas zu dem Verarbeitungsraum (102);
eine Stützeinheit (300), die ein Spannfutter (310), das ein Substrat (W) in dem Verarbeitungsraum (102) stützt, und eine untere Elektrode (350) einschließt, die bereitgestellt ist, um das Spannfutter (310) zu umgeben, wenn von oben betrachtet;
eine dielektrische Platteneinheit (500), die eine dielektrische Platte (520) beinhaltet, die gegenüber dem Substrat (W) angeordnet ist, das von der Stützeinheit (300) in dem Verarbeitungsraum (102) gestützt wird;
eine obere Elektrodeneinheit (600), die an die dielektrische Platteneinheit (500) gekoppelt ist, und
eine obere Elektrode (620), die gegenüber der unteren Elektrode (350) angeordnet ist; und **dadurch gekennzeichnet, dass** die Einrichtung ferner Folgendes umfasst:
eine Ausrichtungseinheit (200) zum Ausrichten einer Anordnung in einer horizontalen Richtung der dielektrischen Platteneinheit (500), wobei ein oberer Abschnitt des Gehäuses (100) mit einer Führung (650) versehen ist, die sich in der horizontalen Richtung von dem Gehäuse (100) erstreckt und an die obere Elektrodeneinheit (600) gekoppelt ist, und die Ausrichtungseinheit (200) an die Führung (650) gekoppelt ist.

2. Substratverarbeitungseinrichtung nach Anspruch 1, wobei die Ausrichtungseinheit (200) Folgendes einschließt:
einen Körper (210), der an die Führung (650) gekoppelt ist; und
eine Vielzahl von Ausrichtungsbolzen (220), die in in dem Körper (210) ausgebildete Gewinde einführbar bereitgestellt sind und zum Schieben der oberen Elektrodeneinheit (600) in die horizontale Richtung bereitgestellt sind.

3. Substratverarbeitungseinrichtung nach Anspruch 2, wobei der Körper (210) in einer Form bereitgestellt ist, die von der Führung (650) abnehmbar ist.

4. Substratverarbeitungseinrichtung nach Anspruch 2, wobei die Führung (650) in einer Ringgestalt bereitgestellt ist, und
die Ausrichtungsbolzen (220) bereitgestellt sind, um eine Mitte der Führung (650) symmetrisch zu sein.

5. Substratverarbeitungseinrichtung nach Anspruch 1, wobei die Führung mit der oberen Elektrodeneinheit (600) durch einen Bolzen (220) gekoppelt ist.

6. Substratverarbeitungseinrichtung nach einem der Ansprüche 1 bis 5, ferner umfassend:
eine Sichtöffnung (525), die die dielektrische Platteneinheit (500) durchdringt;
eine Ausrichtungsmarkierung (315), die an der Stützeinheit (300) bereitgestellt ist, um der Sichtöffnung (525) an einer voreingestellten Position zu entsprechen.

7. Substratverarbeitungseinrichtung nach Anspruch 6, wobei, wenn von oben betrachtet, die Sichtöffnung (525) an einer Position bereitgestellt ist, die die Führung (650) nicht überlappt.

8. Substratverarbeitungseinrichtung nach Anspruch 1, wobei die dielektrische Platteneinheit (500) und die obere Elektrodeneinheit (600) an eine Temperatursteuerungsplatte (700) gekoppelt sind.

9. Substratverarbeitungseinrichtung nach Anspruch 8, wobei die dielektrische Platteneinheit (500) ferner eine erste Basis (510) einschließt, die zwischen der dielektrischen Platte (520) und der Temperatursteuerungsplatte (700) angeordnet ist,
die obere Elektrodeneinheit (600) ferner eine zweite Basis (610) einschließt, die die erste Basis (510) umgibt, wenn von oben betrachtet, und zwischen der oberen Elektrode (620) und der Temperatursteuerungsplatte (700) angeordnet ist.

10. Substratverarbeitungseinrichtung nach Anspruch 9, wobei die Gaszufuhreinheit Folgendes einschließt:
einen Gaskanal, der in einem Raum gebildet ist, in welchem die erste Basis (510) und die zweite Basis (610) voneinander beabstandet sind;
eine erste Gaszufuhreinheit (810) zum Zuführen von zu Plasma angeregtem Verarbeitungsgas in den Gaskanal;
einen Gasströmungsweg, der innerhalb der dielektrischen Platte (520) bereitgestellt ist; und
eine zweite Gaszufuhreinheit (830) zum Zuführen von Inertgas in den Gasströmungsweg, wobei ein Auslassende des Gaskanals einen Randbereich des Substrats (W) leitet, das von der Stützeinheit (300) gestützt wird, und
ein Auslassende des Gasströmungswegs gebildet ist, um einen zentralen Bereich des Substrats (W), das von der Stützeinheit (300) gestützt wird, zu leiten.

11. Verfahren zum Ausrichten der dielektrischen Platte unter Verwendung der Substratverarbeitungseinrichtung nach Anspruch 2, das Verfahren umfassend:
Ausrichten der dielektrischen Platte (520) auf eine voreingestellte Position relativ zur Stützeinheit (300) vor oder nach der Verarbeitung des Substrats (W) innerhalb des Verarbeitungsraums (102),
wobei, wenn die dielektrische Platte (520) nicht in der voreingestellten Position ausgerichtet ist, die dielektrische Platte (520) in der voreingestellten Position ausgerichtet wird, indem eine der Ausrichtungsbolzen (220) festgezogen wird, um die obere Elektrodeneinheit (600) von einer Seite zur anderen zu bewegen.

12. Verfahren nach Anspruch 11, wobei die Ausrichtungseinheit (200) abnehmbar von der Führung (650) bereitgestellt ist.

13. Verfahren nach Anspruch 11, wobei die Führung (650) mit der oberen Elektrodeneinheit (600) durch einen Bolzen (220) gekoppelt ist,
die Führung (650) und die obere Elektrodeneinheit (600) vollständig miteinander gekoppelt sind, während das Substrat (W) innerhalb des Verarbeitungsraums (102) verarbeitet wird, und die Führung (650) und die obere Elektrodeneinheit (600) lose miteinander gekoppelt sind, während die dielektrische Platte (520) ausgerichtet wird.

14. Verfahren nach Anspruch 11, wobei die voreingestellte Position für die Ausrichtung der dielektrischen Platte (520) eine Position ist, an welcher die Stützeinheit (300) platziert wird, während das Substrat (W) innerhalb des Verarbeitungsraums (102) verarbeitet wird.

15. Verfahren nach einem der Ansprüche 11 bis 14, wobei eine der Ausrichtungsbolzen (220) festgezogen wird, sodass eine Sichtöffnung (515), die die dielektrische Platteneinheit (500) durchdringt, und eine Ausrichtungsmarkierung (315), die an der Stützeinheit (300) bereitgestellt ist, um der Sichtöffnung (515) zu entsprechen, miteinander fluchten.

## Revendications

1. Appareil de traitement de substrat, l'appareil de traitement de substrat comprenant :
un boîtier (100) avec un haut ouvert et comportant un espace de traitement (102) à l'intérieur de celui-ci ;
une unité d'alimentation en gaz (800) destinée à délivrer du gaz à l'espace de traitement (102) ;
une unité de support (300) comprenant un mandrin (310) supportant un substrat (W) dans l'espace de traitement (102) et une électrode inférieure (350) prévue pour entourer le mandrin (310) lorsqu'elle est vue de dessus ;
une unité de plaque diélectrique (500) comprenant une plaque diélectrique (520) disposée à l'opposé du substrat (W) supporté par l'unité de support (300) dans l'espace de traitement (102) ;
une unité d'électrode supérieure (600) couplée à l'unité de plaque diélectrique (500), et comprenant
une électrode supérieure (620) disposée à l'opposé de l'électrode inférieure (350) ; et
**caractérisé en ce que** l'appareil comprend en outre :
une unité d'alignement (200) destinée à aligner une disposition dans une direction horizontale de l'unité de plaque diélectrique (500),
dans lequel une partie haute du boîtier (100) est pourvue d'un conducteur (650) s'étendant dans la direction horizontale à partir du boîtier (100) et couplé à l'unité d'électrode supérieure (600), et l'unité d'alignement (200) est couplée au conducteur (650).

2. Appareil de traitement de substrat selon la revendication 1, dans lequel l'unité d'alignement (200) comprend :
un corps (210) couplé au conducteur (650) ; et
une pluralité de boulons d'alignement (220) prévus de manière insérable dans des filets formés dans le corps (210) et prévus pour pousser l'unité d'électrode supérieure (600) dans la direction horizontale.

3. Appareil de traitement de substrat selon la revendication 2, dans lequel le corps (210) est fourni sous une forme détachable du conducteur (650).

4. Appareil de traitement de substrat selon la revendication 2, dans lequel le conducteur (650) est prévu sous une forme annulaire, et
les boulons d'alignement (220) sont prévus pour être symétriques par rapport à un centre du conducteur (650).

5. Appareil de traitement de substrat selon la revendication 1, dans lequel le conducteur est couplé à l'unité d'électrode supérieure (600) par l'intermédiaire d'un boulon (220).

6. Appareil de traitement de substrat selon l'une quelconque des revendications 1 à 5, comprenant en outre :
un orifice d'observation (525) pénétrant dans l'unité de plaque diélectrique (500) ; et
une marque d'alignement (315) prévue sur l'unité de support (300) pour correspondre à l'orifice d'observation (525) à une position prédéfinie.

7. Appareil de traitement de substrat selon la revendication 6, dans lequel, lorsqu'il est vu de dessus, l'orifice d'observation (525) est prévu au niveau d'une position qui ne chevauche pas le conducteur (650).

8. Appareil de traitement de substrat selon la revendication 1, dans lequel l'unité de plaque diélectrique (500) et l'unité d'électrode supérieure (600) sont couplées à une plaque de commande de température (700).

9. Appareil de traitement de substrat selon la revendication 8, dans lequel l'unité de plaque diélectrique (500) comprend en outre une première base (510) disposée entre la plaque diélectrique (520) et la plaque de commande de température (700), et
l'unité d'électrode supérieure (600) comprend en outre une seconde base (610) qui entoure la première base (510) lorsqu'elle est vue de dessus, et est disposée entre l'électrode supérieure (620) et la plaque de commande de température (700).

10. Appareil de traitement de substrat selon la revendication 9, dans lequel l'unité d'alimentation en gaz comprend :
un canal de gaz formé dans un espace dans lequel la première base (510) et la seconde base (610) sont espacées l'une de l'autre ;
une première unité d'alimentation en gaz (810) destinée à délivrer du gaz de procédé excité au plasma dans le canal de gaz ;
un trajet d'écoulement de gaz prévu à l'intérieur de la plaque diélectrique (520) ; et
une seconde unité d'alimentation en gaz (830) destinée à délivrer du gaz inerte dans le trajet d'écoulement du gaz,
une extrémité de décharge du canal de gaz est orientée vers une région de bord du substrat (W) supporté par l'unité de support (300), et
une extrémité de décharge du trajet d'écoulement de gaz est formée de manière à être orientée vers une région centrale du substrat (W) supporté par l'unité de support (300).

11. Procédé d'alignement de la plaque diélectrique à l'aide de l'appareil de traitement de substrat selon la revendication 2, le procédé comprenant :
l'alignement de la plaque diélectrique (520) à une position prédéfinie par rapport à l'unité de support (300) avant ou après le traitement du substrat (W) dans l'espace de traitement (102),
dans lequel, lorsque la plaque diélectrique (520) n'est pas alignée dans la position prédéfinie, la plaque diélectrique (520) est alignée dans la position prédéfinie en serrant l'un quelconque des boulons d'alignement (220) pour déplacer l'unité d'électrode supérieure (600) d'un côté à l'autre.

12. Procédé selon la revendication 11, dans lequel l'unité d'alignement (200) est fournie de manière détachable du conducteur (650).

13. Procédé selon la revendication 11, dans lequel le conducteur (650) est couplé à l'unité d'électrode supérieure (600) par l'intermédiaire d'un boulon (220),
le conducteur (650) et l'unité d'électrode supérieure (600) sont entièrement couplés l'un à l'autre tandis que le substrat (W) est en cours de traitement dans l'espace de traitement (102), et
le conducteur (650) et l'unité d'électrode supérieure (600) sont couplés de manière lâche l'un à l'autre tandis que la plaque diélectrique (520) est en cours d'alignement.

14. Procédé selon la revendication 11, dans lequel la position prédéfinie pour l'alignement de la plaque diélectrique (520) est une position à laquelle l'unité de support (300) est placée tandis que le substrat (W) est en cours de traitement à l'intérieur de l'espace de traitement (102).

15. Procédé selon l'une quelconque des revendications 11 à 14, dans lequel l'un quelconque des boulons d'alignement (220) est serré de sorte qu'un orifice d'observation (515) pénétrant dans l'unité de plaque diélectrique (500) et une marque d'alignement (315) prévue sur l'unité de support (300) pour correspondre à l'orifice d'observation (515) sont alignés l'un avec l'autre.
